# EUROPÄISCHE PATENTSCHRIFT

(11) **EP 0 810 673 B1**
(45) Veröffentlichungstag und Bekanntmachung des Hinweises auf die Patenterteilung: **30.08.2000**
(21) Anmeldenummer: 97107463.8
(22) Anmeldetag: 06.05.1997
(51) Int. Cl.: H01L 29/788, H01L 27/115

(54) **Halbleiterbauelement mit Kompensationsimplantation und Herstellverfahren**
Semiconductor device with compensation implantation and method of manufacture
Dispositif semi-conducteur avec l'implantation de compensation et procédé de fabrication

(30) Priorität: 17.05.1996 DE 19620032
(43) Veröffentlichungstag der Anmeldung: 03.12.1997
(73) Patentinhaber: SIEMENS AKTIENGESELLSCHAFT, 80333 München (DE)
(72) Erfinder: Kakoschke, Ronald, Dr.rer.nat., 81475 München (DE); Sedlak, Holger, Dipl.-Inf., 85658 Egmating (DE)

(56) Entgegenhaltungen:
- US-A- 5 063 423
- PATENT ABSTRACTS OF JAPAN vol. 012, no. 337 (E-657), 12.September 1988 & JP 63 099573 A (SONY CORP), 30.April 1988,
- IEEE TRANSACTIONS ON ELECTRON DEVICES, Bd. ED-33, Nr. 2, Februar 1986, NEW YORK, USA, Seiten 275-281, XP002036618 HIROSHI NOZAWA, NAOHIRO MATSUKAWA, AND SHIGERU MORITA: "An EEPROM Cell Using a Low Barrier Height Tunnel Oxide"
- SOLID-STATE ELECTRONICS/PERGAMON PRESS, Bd. 35, Nr. 10, Oktober 1992, Seiten 1513-1520, XP002036680 MING-BING CHANG, UMESH SHARMA AND SHIH K. CHENG: "AN IMPROVED MODEL FOR THE ERASE OPERATION OF A FLOTOX CELL"

## Beschreibung

Die Erfindung betrifft ein Halbleiterbauelement mit einem ersten und einem zweiten dotierten Gebiet eines ersten Leitungstyps, welche in einem Halbleitersubstrat eines zweiten Leitungstyps angeordnet sind, und mit einem Kanalgebiet im Halbleitersubstrat zwischen den beiden dotierten Gebieten, insbesondere betrifft sie EEPROM-Speicherzellen.

EEPROM-Zellen (electrically erasable and programmable read only memories) spielen eine immer wichtigere Rolle unter den Speichertypen. Beispielsweise werden für Chipkartenanwendungen Speicherblöcke vom FLOTOX Zelltyp (floating gate tunnel oxide) eingesetzt, die in eine Mikrokontroller-Umgebung integriert sind (embedded Memories). Dabei besteht ein Bedarf an immer kleineren Zellen. Ein begrenzender Faktor ist die Shrinkbarkeit des Tunnelfensters mit dem dazugehörigen elektrischen Anschlußgebiet (Buried Channel). Diese Grenze ist in erster Linie durch die Eigenschaften des Devices bestimmt, wie im folgenden und in der DE OS 196 14 010 ("Halbleiterbauelement mit einstellbarer, auf einem tunnelstromgesteuerten Lawinendurchbruch basierender Stromverstärkung" desselben Anmelders) beschrieben ist.

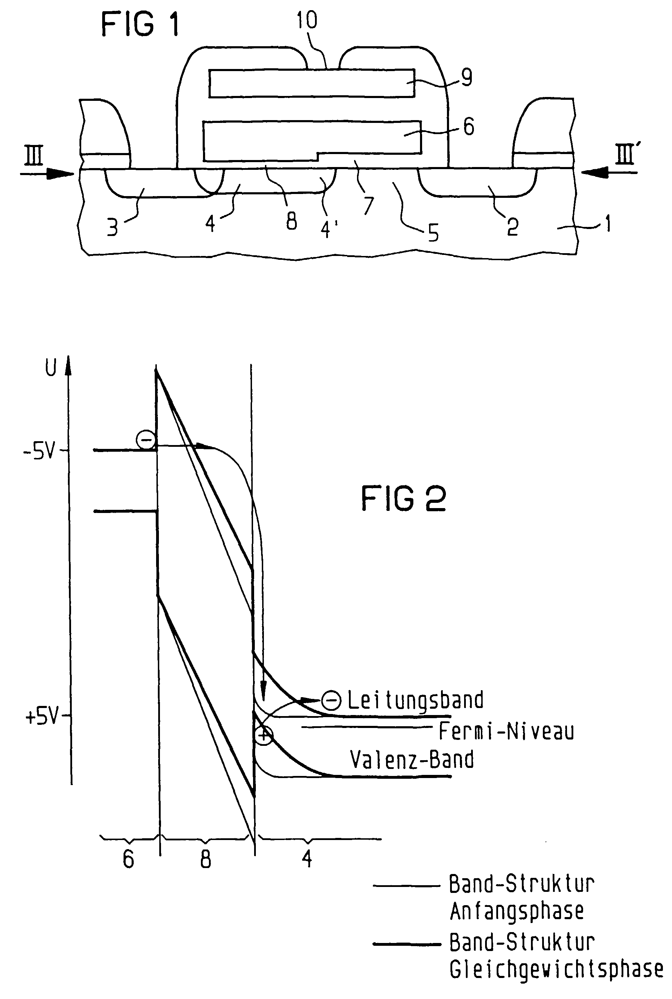

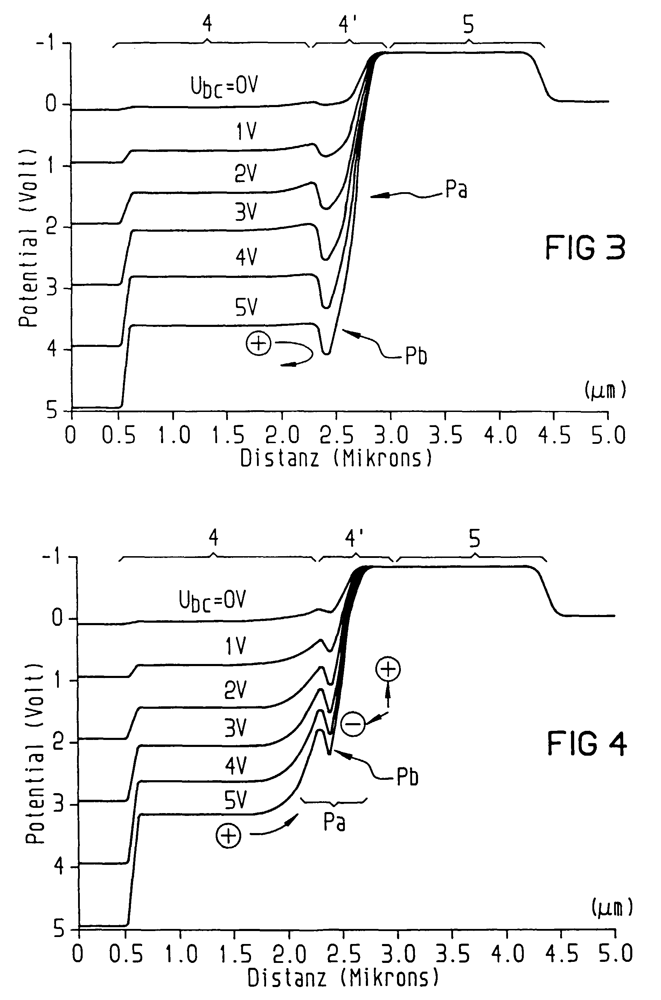

In Fig. 1 ist eine EEPROM-Zelle vom FLOTOX Typ schematisch dargestellt. In einem p-dotierten Halbleitersubstrat 1 befinden sich zwei n-dotierte Gebiete 2, 3 als Source und Drain. Auf der dazwischen liegenden Substratoberfläche ist ein Floating Gate 6 angeordnet, das durch ein Gatedielektrikum 7 bzw. ein Tunneldielektrikum 8 vom Substrat getrennt ist. Das Floating Gate ist über das Tunneldielektrikum (sog. Tunnelfenster) und über ein als Buried Channel bezeichnetes n-dotiertes Gebiet 4 an das Drain "angeschlossen". Der Bereich unter dem Gateoxid des Speichertransistors, das sog. Kanalgebiet 5, ist schwach p-dotiert. Das Gatedielektrikum 7 bedeckt nicht nur das Kanalgebiet 5, sondern auch einen Randbereich 4' des Buried Channel 4. Über dem Floating Gate 6 ist ein Control Gate 9 mit einem Anschluß 10 angeordnet. Zum Programmieren werden in etwa folgende Spannungen eingestellt:
U_{controlgate} = 0V
U_{Drain} = +15V
U_{Source} floatend
Elektronen können dabei aus dem Floating-Gate durch die Potentialbarriere im Oxid ins Leitungsband des Oxids und dann ins Substrat gelangen, dies ist als Bänderdiagramm in Fig.2 dargestellt. Dabei nehmen sie genug Energie auf, um im Substrat Elektron-Lochpaare zu erzeugen. (Löcher haben die Tendenz, an der Oberkante des Valenzbandes entlang zu höherem Potential - also in der Zeichnung nach oben - zu laufen, da dies einem für Löcher niedrigeren Potential entspricht.)

In Fig.3 ist der Potentialverlauf entlang der Grenzfläche senkrecht zur Zeichenebene der Fig.2 (also entlang der Achse III - III' in Fig 1) bei großer lateraler Ausdehnung des Randbereichs 4' für verschiedenen Werte von U_{buried channel} gezeigt. Der pn-Übergang zwischen Buried Channel 4 (n-dotiert) und Substrat (p-dotiert) ist bei den genannten Spannungen in Sperrichtung gepolt. Dies führt zu einem starken Potentialgefälle. Am Übergang Tunnel-zu-Gatedielektrikum bildet sich sowohl im Leitungs- als auch im Valenzband noch eine kleine Potentialbarriere Pb aus, da das Potential an der Grenzfläche von der Dicke des überliegenden Dielektrikum abhängt: das Löcherpotential im Tunneloxidgebiet ist höher als im Gateoxidgebiet. Der Löcherpotentialabfall Pa zum p-Gebiet setzt erst mit dem Konzentrationsabfall der Dotierung ein. Wenn die Höhe dieser Potentialbarriere immer (für Löcher) über dem Buried Channel-Potential liegt, können Löcher nicht aus dem Buried Channel-Gebiet 4 entweichen.

Fig 4: Ist die laterale Ausdehnung des Randbereichs 4' unter dem Gatedielektrikum 7 nicht ausreichend, setzt der Löcherpotentialabfall Pa früher ein. Die Barriere Pb liegt im abfallenden Ast und fällt unter das Buried Channel-Niveau Ab. Daher können die durch die Tunnelelektronen erzeugten Löcher aus dem Gebiet unter dem Tunneldielektrikum 8 entweichen und das Löcherpotentialgefälle zum Kanalgebiet 5 hin durchlaufen. Löcher werden nun nicht mehr im Buried Channel-Gebiet gehalten. Dabei werden durch Stoßionisation weitere Elektron-Lochpaare erzeugt. Es kommt zu einer Ladungsmultiplikation, so daß der Strom vom Buried Channel 4 zum Kanalgebiet 5, d.h. ins Substrat 1, um viele Größenordnungen (10⁴ bis 10⁶) über dem Tunnelstrom liegt. Die Ladungspumpe zur Erzeugung der Programmierspannung kann diesen Strom nicht liefern. Die Zellen können nicht in der erforderlichen Zeit von einigen Millisekunden programmiert werden. Der durch die Ladungsmultiplikation erzeugte parasitäre Strom belastet außerdem das Tunneloxid und reduziert damit die Zykelfestigkeit (Anzahl möglicher Programmier-/Löschvorgänge).

Die Höhe der Potentialbarriere ist von entscheidender Bedeutung für den Programmiervorgang und die elektrische Zuverlässigkeit des Bauelementes. Sie kann eingestellt werden:
- durch die laterale Ausdehnung des Randbereichs 4'
- durch das Dickenverhältnis Tunneldielektrikum zu Gatedielektrikum
- durch das laterale Dotierprofil um die Gateoxid-Tunneloxidkante.

Um einen ausreichende Ausdehnung des Randbereichs 4' unter dem Gatedielektrikum 7 zu erhalten, ist eine hohe laterale Ausdiffusion des n-dotierenden Elements (meist Phosphor) notwendig. Dies ist durch eine hohe Implantationsdosis zu erreichen. Der Abstand Gateoxid-Tunneloxidkante zum Source-Gebiet muß entsprechend groß sein, damit die Kanallänge des Speichertransistors durch die laterale Diffusion nicht zu kurz wird. Eine hohe Buried Channel-Konzentration wirkt sich außerdem ungünstig auf die Qualität des Tunneloxids aus. Weiter wird die ausreichende Ausdehnung des Randbereichs 4' meist dadurch sichergestellt, daß zur Definition des Buried Channels 4 und des Tunnelfensters zwei verschiedenen Masken verwendet werden, die Implantationsmaske für den Buried Channel also eine größere Öffnung aufweist als die Ätzmaske für das Tunnelfenster.

Ein anderer Weg zur Vermeidung des Lawinendurchbruchs ist ein großes Dickenverhältnis von Gate- zu Tunneldielektrikum (≥ 4). Soll dies Verhältnis verkleinert werden, stößt man an die lateralen Shrink-Grenzen des Bauelements.

In dem Artikel von Hiroshi Nowaza et al, IEEEE Transactions ED-33, Nr.2, Feb. 86, S.275 - 281 ist eine EEPROM-Zelle beschrieben, bei der das dotierte Gebiet unterhalb des Tunnelfensters in zwei Schritten mit unterschiedlichen Prozeßparametern implantiert wird, so daß es einen zentralen Bereich mit hoher Dotierstoffkonzentration und einen Randbereich mit geringerer Dotierstoffkonzentration aufweist.

In Patent Abstracts of Japan, Vol.12, No.337(E-657) ist eine EEPROM-Zelle offenbart, bei der zur Verringerung des Hot-Carrier-Effektes das Gebiet unterhalb des Tunnelfensters geringer dotiert wird als das Drain-Gebiet.

Aufgabe der Erfindung ist daher die Schaffung eines EPROMs mit einem geringen Platzbedarf und einer hohen elektrischen Zuverlässigkeit. Diese Aufgabe wird durch ein Halbleiterbauelement mit den Merkmalen des Patentanspruchs 1 gelöst. Weiterbildungen sind Gegenstand von Unteransprüchen.

Bei der Erfindung wird die Höhe der Potentialbarriere durch das laterale Dotierstoffprofil eingestellt. Dabei wird folgende Erkenntnis ausgenutzt: Je schwächer die effektive Dotierung im Buried Channel ist, um so höher ist das Potential an der Grenzfläche (d.h., das Löcherpotential ist niedriger). Eine hohe Potentialbarriere kann erzielt werden durch ein hohes Potential im Buried Channel und ein niedriges Potential im Randbereich, d. h. unter dem Gatedielektrikum bzw. an der Grenze zwischen Gate- und Tunneldielektrikum, also durch eine schwache Dotierung im Buried Channel und eine höhere Dotierung im Randbereich. Das laterale Dotierstoffprofil in der Nähe der Halbleitersubstratoberfläche weist also zumindest ein lokales Maximum im Randbereich auf. Die effektive Konzentration von n-Dotierstoffen ist im Randbereich größer als in einem Bereich unterhalb des Tunnelfensters.

Ein solches Dotierprofil kann dadurch hergestellt werden, daß zusätzlich zu der Implantation des Buried Channel eine Kompensationsimplantation mit Dotieratomen des entgegengesetzten Leitungstypes durchgeführt wird, bei der die laterale Ausdiffusion geringer ist als bei der Buried Channel-Implantation. Dafür wird dieselbe Implantationsmaske eingesetzt, die gegebenenfalls modifiziert wird.

Die Erfindung wird im folgenden anhand von Ausführungsbeispielen, die in den Zeichnungen dargestellt sind, näher erläutert. Es zeigen
- Figur 1:: Einen Querschnitt durch ein Halbleitersubstrat mit einer bekannten EEPROM-Speicherzelle,
- Figur 2 bis 4:: den Potentialverlauf im Halbleitersubstrat entlang vorgegebener Achsen,
- Figur 5 bis 7 und Figur 8 bis 10:: einen Querschnitt durch ein Halbleitersubstrat, an dem zwei Ausführungsformen zur Herstellung des Halbleiterbauelementes dargestellt werden,
- Figur 11 und 12:: das laterale Dotierprofil und das Grenzflächenpotential ohne bzw. mit Kompensationsimplantation.

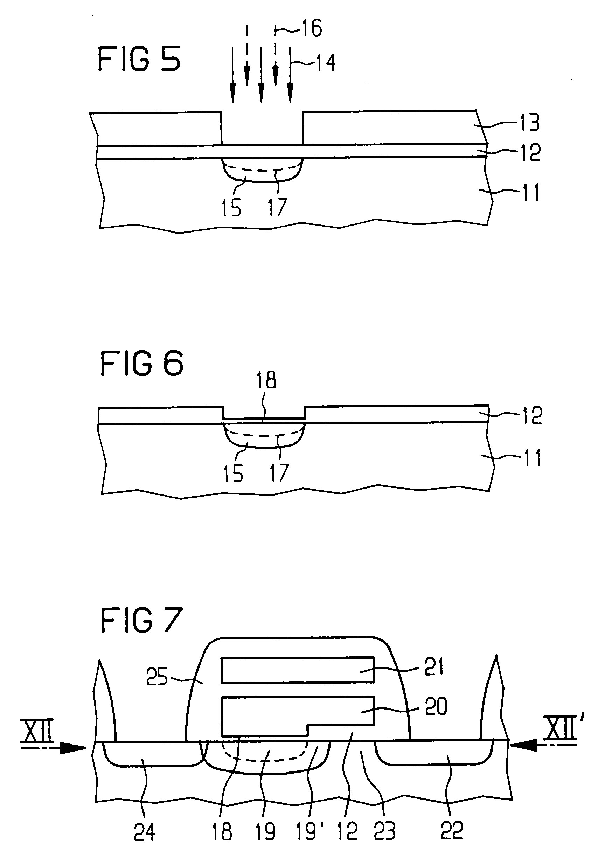

Figur 5: Auf einem p-dotierten Siliziumsubstrat 11 werden ein Gatedielektrikum 12, beispielsweise ein Gateoxid von 20 nm Dicke, und darüber eine Maske 13 aufgebracht. Die Maske besitzt an der Stelle des späteren Buried Channel bzw. des Tunnelfensters eine Öffnung, durch die ein n-Dotierstoff 14, beispielsweise Phosphor, implantiert wird. Das Gateoxid 12 wirkt dabei als Streuoxid. Im Substrat 11 entsteht ein n-dotierter Bereich 15. Anschließend wird unter Verwendung derselben Maske 13 eine Kompensationsimplantation durchgeführt, indem ein p-Dotierstoff 16 implantiert wird, der eine niederigere Diffusionsgeschwindigkeit aufweist. Die Implantationsdosis ist dabei geringer als bei der Buried Channel-Implantation, so daß im Halbleitersubstrat ein weiterer dotierter Bereich 17 innerhalb des dotierten Bereiches 15 entsteht, der eine schwächere n-Dotierung aufweist als der Bereich 15. Die Buried Channel-Implantation wird beispielsweise mit Phosphor mit 150 keV Implantationsenergie und 4 x 10¹⁴ cm⁻² Implantationsdosis durchgeführt, die Kompensationsimplantation wird beispielsweise mit Gallium mit 100 keV Implantationsenergie und 1 x 10¹³ cm⁻² Implantationsdosis durchgeführt.

Figur 6: Unter Verwendung der Maske 13 wird nun das Gateoxid geätzt, dann wird die Maske entfernt und als Tunneldielektrikum ein Oxid 18 von etwa 8 nm Dicke aufgebracht, so daß ein Tunnelfenster entsteht.

Figur 7: Mit bekannten Verfahren wird die EEPROM-Zelle fertiggestellt. Durch die dabei auftretenden Temperaturbelastungen oder in Folge eines eigens eingesetzten Temperaturschrittes wird aus dem dotierten Gebiet 15 und dem weiteren dotierten Gebiet 17 ein als Buried Channel bezeichnetes erstes dotiertes Gebiet 19 gebildet, dessen Randbereich 19' sich unter das Gateoxid 12 erstreckt. Dieser Randbereich 19' weist eine höhere effektive Dotierung auf als ein direkt unter dem Tunneloxid liegender Teil des ersten dotierten Gebietes 19. Dieses laterale Dotierungsprofil ist dadurch verursacht, daß Gallium im Vergleich zu Phosphor nur sehr langsam diffundiert, so daß die Kompensationsimplantation die Nettodotierung im wesentlichen nur unter dem Tunnelfenster senkt (also im Bereich des weiteren dotierten Gebietes 17) nicht aber außerhalb des Tunnelfensters (also insbesondere nicht in dem oben definierten Randbereich 19' unter dem Gateoxid). Die Konzentration der p-Dotieratome im Randbereich ist sehr viel niedriger (typischerweise um mindestens zwei Größenordnungen) als unter dem Tunnelfenster.

Das EEPROM weist ferner eine Gateelektrode 20 als Floating Gate auf, die auf dem Tunneloxid 18 und dem Gateoxid 12 angeordnet ist, sowie eine isoliert darauf angebrachte Elektrode 21 als Control Gate. Das Control Gate ist von außen anschließbar. Das EEPROM wird vervollständigt durch ein zweites n-dotiertes Gebiet 22, wobei das zwischen dem ersten 19 und zweiten dotierten Gebiet 22 liegende Gebiet des Halbleitersubstrates das sogenannte Kanalgebiet 23 darstellt und an seiner Oberfläche mit dem Gateoxid 12 bedeckt ist. Ein n-dotiertes Gebiet 24 dient zum Anschluß des Buried Channel 19. Floating Gate 20 und Control Gate 21 sind mit einer Isolation 25 eingekapselt.

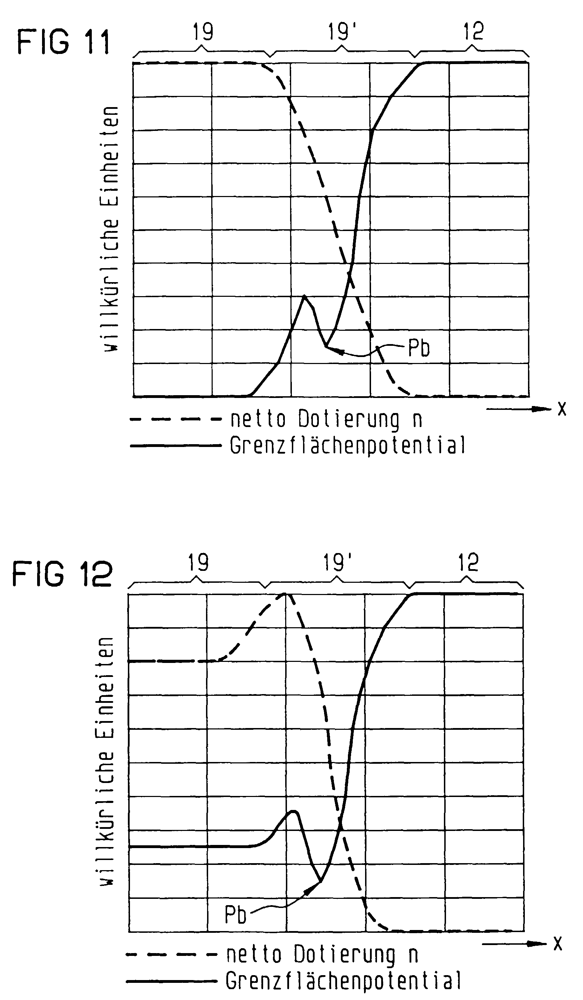

Durch das laterale Dotierprofil im Halbleitersubstrat beim Übergang von Buried Channel 19 zu Kanalgebiet 23, das in Figur 12 dargestellt ist, wird das Potential im Buried Channel angehoben (bzw. das Löcherpotential im Buried Channel gesenkt), im Bereich der Barriere (Randbereich 19') dagegen nicht. Die Potentialbarriere wird dadurch effektiv erhöht. Um eine Potentialbarriere von vorgegebener Höhe zu erhalten, ist eine gegenüber konventionellen Verfahren verringerte Phosphor-Implantationsdosis notwendig, und die laterale Ausdiffusion des Phosphors kann verringert werden. Bei gleicher Länge des Kanalgebietes 23 ist daher ein kleinerer Abstand zwischen Tunnelfensterkante und dem zweiten n-dotierten Gebiet 22 (als Source bezeichnet) realisierbar.

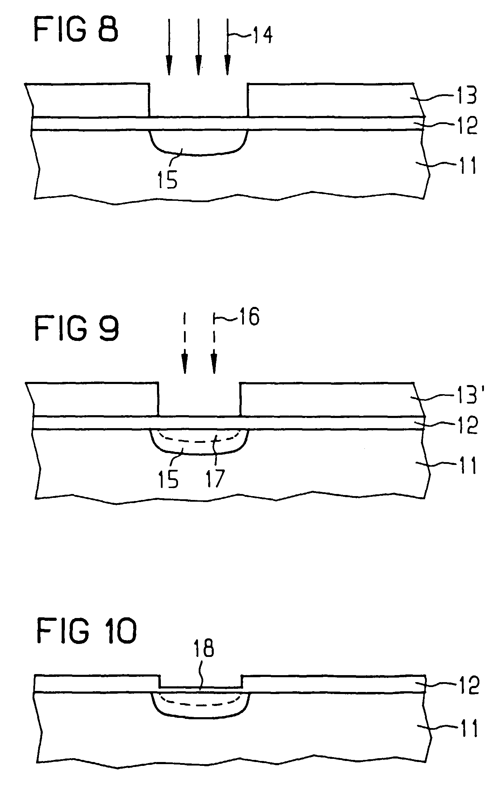

Figur 8: Für das zweite Ausführungsbeispiel zur Herstellung des Halbleiterbauelementes wird wiederum von einem p-Siliziumsubstrat 11 mit einem Gateoxid 12 und einer Maske 13 ausgegangen. Ein n-Dotierstoff 14 wird implantiert, so daß ein n-dotierter Bereich 15 im Halbleitersubstrat 11 entsteht. Vorzugsweise wird Phosphor mit 150 keV Implantationsenergie und 4 x 10¹⁴ cm⁻² Implantationsdosis implantiert.

Figur 9: Dann wird die Größe der Öffnung in der Maske 13 geändert, z. B. bei einer aus Fotolack bestehenden Maske wird durch Aufquellen wird die Öffnung verkleinert, so daß eine modifizierte Maske 13' entsteht. Dazu kann die sogenannte CARL-Technik (chemische Aufweitung von Resist-Linien), wie in EP 0 395 917 beschrieben, eingesetzt werden. Anschließend erfolgt die Kompensationsimplantation mit einem p-Dotierstoff, beispielsweise Bor mit 10 keV Implantationsenergie und 1 x 10¹³ cm⁻² Implantationsdosis, so daß der weitere dotierte Bereich 17 erzeugt wird. Dieser Bereich 17 liegt vollständig innerhalb des n-dotierten Bereiches 15, insbesondere hat er an der Substratoberfläche kleinere laterale Ausmaße.

Figur 10: Anschließend wird unter Verwendung der modifizierten Maske 13' das Gateoxid 12 entfernt und ein Tunneloxid 18 aufgebracht. Die übrige Verfahrensweise ist wie beim ersten Ausführungsbeispiel.

Die Modifikation der Implantationsmaske 13 kann auch in anderer Weise erfolgen, beispielsweise durch Herstellen von Spacern an den Seitenwänden der Öffnung. Ferner kann die Reihenfolge der Implantationen getauscht werden, d. h. zunächst die Kompensationsimplantation erfolgen, dann die Öffnung in der Maske vergrößert werden, und schließlich die Buried Channel-Implantation erfolgen.

Figur 11 zeigt das laterale Dotierprofil entlang der x-Achse III-III' in Figur 1 (n-Netto-Dotierung) in willkürlichen Einheiten als gestrichelte Linie und das sich dabei ergebende Grenzflächenpotential als durchgezogene Linie. Man erkennt, daß bei der monotonen Änderung der Nettodotierung (wie auch in Figur 4 dargestellt) die Potentialbarriere Pb in den abfallenden Ast des Löcherpotentials fällt.

Figur 12 zeigt die gleichen Größen wie Figur 11 (entlang der Achse XII-XII' in Figur 10), wobei eine Kompensationsimplantation durchgeführt wurde. Diese führt zu einem lokalen Maximum der effektiven Dotierung im Randbereich 19' und senkt das Löcherpotential im Bereich des Tunnelfensters 18. Die Potentialbarriere Pb stellt ein Maximum für das Löcherpotential dar, so daß ein Lawinendurchbruch vermieden wird. In einem EEPROM ist die Ladungsmultiplikation beim Programmiervorgang so gering, daß selbst eine schwach dimensionierte Ladungspumpe die Programmierspannung aufrecht erhalten kann.

## Patentansprüche

1. Halbleiterbauelement mit
- einem ersten (19) und einem zweiten dotierten Gebiet (22) eines ersten Leitungstypes, welche in einem Halbleitersubstrat (11) eines zweiten Leitungstypes angeordnet sind,
- einem Kanalgebiet (23) im Halbleitersubstrat zwischen den beiden dotierten Gebieten (19, 22),
- einem Tunneldielektrikum (18), welches eine Oberfläche des ersten dotierten Gebietes (19) teilweise bedeckt,
- einem Gatedielektrikum (12), welches eine Oberfläche des Kanalgebietes (23) sowie einen an das Kanalgebiet anschließenden Randbereich (19') des ersten dotierten Gebietes (19) bedeckt, einer Gateelektrode (20) auf dem Tunneldielektrikum (18) und dem Gatedielektrikum (12),
dadurch gekennzeichnet, daß
der Randbereich (19') eine höhere effektive Dotierung aufweist als der unter dem Tunneldielektrikum (18) liegende Bereich des ersten dotierten Gebietes (19).

2. Halbleiterbauelement nach Anspruch 1,
bei dem in dem unter dem Tunneldielektrikum (18) liegenden Bereich des ersten dotierten Gebietes (19) ein Dotierstoff des ersten Leitungstypes und ein Dotierstoff des zweiten Leitungstypes vorhanden sind.

3. Halbleiterbauelement nach Anspruch 2,
bei dem im Randbereich (19') des ersten dotierten Gebietes (19)der Dotierstoff des ersten Leitungstypes vorhanden ist und die Konzentration des Dotierstoffes des zweiten Leitungstypes sehr viel geringer als im Bereich unter dem Tunneldielektrikum (18) ist.

4. Halbleiterbauelement nach einem der Ansprüche 2 - 3,
bei dem der Dotierstoff des ersten Leitungstypes Phosphor und der Dotierstoff des zweiten Leitungstypes Bor oder Gallium ist.

5. Herstellverfahren für ein Halbleiterbauelement nach einem der Ansprüche 1 - 4 mit folgenden Schritten:
- Erzeugen eines Gatedielektrikums (12) auf einem Halbleitersubstrat (11) eines zweiten Leitungstypes,
- Aufbringen einer Maske (13) auf dem Gatedielektrikum (12), welche im Bereich eines herzustellenden Tunneldielektrikums eine Öffnung aufweist,
- Herstellen eines dotierten Gebietes (15) eines ersten Leitungstypes unterhalb der Öffnung durch eine Implantation durch das Gatedielektrikum (12) hindurch,
- Durchführen einer Kompensationsimplantation mit einem Dotierstoff des zweiten Leitungstypes derart, daß nach den beiden Implantationen die effektive Dotierstoffkonzentration des ersten Leitungstypes im oberflächennahen Bereich unter der Öffnung gesenkt wird und ein an den Kanalbereich angrenzender Randbereich des dotierten in dem fertiggestellten Halbleiterbauelement eine höhere effektive Dotierung aufweist als der dotierte Bereich unter dem Tunneldielektrikum,
- Entfernen des Gatedielektrikums (12) innerhalb der Öffnung der Maske (13),
- Entfernen der Maske (13),
- Erzeugen eines Tunneldielektrikums (18) auf der freiliegenden Halbleitersubstratoberfläche,
- Herstellen einer Gateelektrode (20) auf dem Tunneldielektrikum und einem angrenzenden Teil des Gatedielektrikums,
- Herstellen eines zweiten dotierten Gebietes (22) des ersten Leitungstypes benachbart zum Kanalgebiet (23) und
- Herstellen eines Anschlusses (24) für das erste dotierte Gebiet (19).

6. Herstellverfahren nach Anspruch 5,
bei dem die Implantation des ersten dotierten Gebietes (19) mit Phosphor erfolgt.

7. Herstellverfahren nach einem der Ansprüche 5 - 6,
bei dem die Kompensationsimplantation mit Gallium erfolgt.

8. Herstellverfahren nach einem der Ansprüche 5 - 6,
bei dem die Maske (13) in ihren lateralen Dimensionen vor der Kompensationsimplantation modifiziert wird.

9. Herstellverfahren nach Anspruch 8,
bei dem die Maske (13) aus Fotolack besteht, der vor der Kompensationsimplantation aufgequollen wird.

10. Herstellverfahren nach einem der Ansprüche 8 - 9,
bei dem die Kompensationsimplantation mit Bor erfolgt.

11. Herstellverfahren nach einem der Ansprüche 5 - 10,
bei dem die Kompensationsimplantation vor der Implantation mit dem Dotierstoff des ersten Leitungstypes durchgeführt wird.

12. Herstellverfahren nach einem der Ansprüche 5 - 11,
bei dem die Kompensationsimplantation mit niedrigerer Dosis als die Implantation mit dem Dotierstoff des ersten Leitungstypes erfolgt.

## Claims

1. Semiconductor device having
- a first (19) and a second doped region (22) of a first conduction type, which are arranged in a semiconductor substrate (11) of a second conduction type,
- a channel region (23) in the semiconductor substrate between the two doped regions (19, 22),
- a tunnel dielectric (18), which partly covers a surface of the first doped region (19),
- a gate dielectric (12), which covers a surface of the channel region (23) and also an edge zone (19') of the first doped region (19), which edge zone adjoins the channel region, having a gate electrode (20) on the tunnel dielectric (18) and the gate dielectric (12),
characterized in that
the edge zone (19') has a higher effective doping than that zone of the first doped region (19) which lies under the tunnel dielectric (18).

2. Semiconductor device according to Claim 1,
in which a dopant of the first conduction type and a dopant of the second conduction type are present in that zone of the first doped region (19) which lies under the tunnel dielectric (18).

3. Semiconductor device according to Claim 2,
in which, in the edge zone (19') of the first doped region (19) the dopant of the first conduction type is present and the concentration of the dopant of the second conduction type is very much lower than in the zone under the tunnel dielectric (18).

4. Semiconductor device according to one of Claims 2 - 3,
in which the dopant of the first conduction type is phosphorus and the dopant of the second conduction type is boron or gallium.

5. Method for fabricating a semiconductor device according to one of Claims 1 - 4, having the following steps:
- production of a gate dielectric (12) on a semiconductor substrate (11) of a second conduction type,
- application of a mask (13) on the gate dielectric (12), which mask has an opening in the region of a tunnel dielectric to be fabricated,
- fabrication of a doped region (15) of a first conduction type underneath the opening by means of an implantation through the gate dielectric (12),
- performance of a compensation implantation with a dopant of the second conduction type in such a way that, after the two implantations, the effective dopant concentration of the first conduction type is lowered in the zone near the surface under the opening and an edge zone, adjoining the channel zone, of the doped region in the completed semiconductor device has a higher effective doping than the doped zone under the tunnel dielectric,
- removal of the gate dielectric (12) within the opening of the mask (13),
- removal of the mask (13),
- production of a tunnel dielectric (18) on the uncovered surface of the semiconductor substrate,
- fabrication of a gate electrode (20) on the tunnel dielectric and an adjoining part of the gate dielectric,
- fabrication of a second doped region (22) of the first conduction type adjacent to the channel region (23), and
- fabrication of a connection (24) for the first doped region (19).

6. Fabrication method according to Claim 5,
in which the implantation of the first doped region (19) is carried out using phosphorus.

7. Fabrication method according to one of Claims 5 - 6,
in which the compensation implantation is carried out using gallium.

8. Fabrication method according to one of Claims 5 - 6,
in which the lateral dimensions of the mask (13) are modified prior to the compensation implantation.

9. Fabrication method according to Claim 8,
in which the mask (13) is composed of photoresists which is swollen prior to the compensation implantation.

10. Fabrication method according to one of Claims 8 - 9,
in which the compensation implantation is carried out using boron.

11. Fabrication method according to one of Claims 5 - 10,
in which the compensation implantation is performed prior to the implantation with the dopant of the first conduction type.

12. Fabrication method according to one of Claims 5 - 11,
in which the compensation implantation is carried out with a lower dose than the implantation with the dopant of the first conduction type.

## Revendications

1. Composant à semi-conducteur comprenant
- une première (19) et une seconde (22) régions dopées d'un premier type de conductivité, qui sont disposées dans un substrat (11) semi-conducteur d'un second type de conductivité,
- une région (23) de canal dans le substrat semi-conducteur entre les deux régions (19, 22) dopées,
- un diélectrique de tunnel (18), qui recouvre partiellement une surface de la première région (19) dopée,
- un diélectrique de grille (12), qui recouvre une surface de la région (23) de canal ainsi qu'une région (19') de bord de la première région (19) dopée qui se raccorde à la région de canal, et une électrode de grille (20) sur le diélectrique de tunnel (18) et sur le diélectrique de grille (12),
caractérisé en ce que
la région (19') de bord a un dopage efficace plus grand que la partie de la première région (19) dopée qui se trouve en dessous du diélectrique de tunnel (18).

2. Composant à semi-conducteur suivant la revendication 1,
dans lequel dans la partie de la première région (19) dopée qui se trouve en dessous du diélectrique de tunnel (18), il y a une substance de dopage du premier type de conductivité et une substance de dopage du second type de conductivité.

3. Composant à semi-conducteur suivant la revendication 2,
dans lequel il y a, dans la partie (19') de bord de la première région (19) dopée, la substance de dopage du premier type de conductivité, et la concentration de la substance de dopage du second type de conductivité est bien plus petite que dans la partie se trouvant en dessous du diélectrique de tunnel (18).

4. Composant à semi-conducteur suivant l'une des revendications 2 ou 3,
dans lequel la substance de dopage du premier type de conductivité est du phosphore et la substance de dopage du second type de conductivité est du bore ou du gallium.

5. Procédé de fabrication d'un composant à semi-conducteur suivant l'une des revendications 1 à 4, et comprenant les stades suivants :
- production d'un diélectrique de grille (12) sur un substrat (11) semi-conducteur d'un second type de conductivité,
- dépôt sur le diélectrique de grille (12) d'un masque (13) qui a une ouverture dans la région d'un diélectrique de tunnel à préparer,
- préparation d'une région (15) dopée d'un premier type de conductivité en dessous de l'ouverture, par implantation à travers le diélectrique de grille (12),
- mise en oeuvre d'une implantation de compensation avec une substance de dopage du deuxième type de conductivité, de façon qu'après avoir effectué les deux implantations, la concentration efficace de substance de dopage du premier type de conductivité dans la partie à proximité de la surface sous l'ouverture soit abaissée, et qu'une partie de bord, adjacente à la région de canal, du composant à semi-conducteur dopé à l'état fini ait un dopage effectif plus grand que la partie dopée en dessous du diélectrique de tunnel,
- élimination du diélectrique de grille.(12) dans l'ouverture du masque (13),
- élimination du masque (13),
- production d'un diélectrique de tunnel (18) sur la surface de substrat semi-conducteur à découvert,
- préparation d'une électrode de grille (20) sur le diélectrique de tunnel et sur une partie adjacente du diélectrique de grille,
- préparation d'une seconde région (22) dopée du premier type de conductivité à proximité de la région (23) de canal, et
- préparation d'une borne (24) pour la première région (19) dopée.

6. Procédé de fabrication suivant la revendication 5,
dans lequel l'implantation de la première région (19) dopée s'effectue avec du phosphore.

7. Procédé de fabrication suivant l'une des revendications 5 ou 6,
dans lequel l'implantation de compensation s'effectue avec du gallium.

8. Procédé de fabrication suivant l'une des revendications 5 ou 6,
dans lequel les dimensions latérales du masque (13) sont modifiées avant l'implantation de compensation.

9. Procédé de fabrication suivant la revendication 8,
dans lequel le masque (13) est en vernis photosensible, qui est gonflé avant l'implantation de compensation.

10. Procédé de fabrication suivant l'une des revendications 8 ou 9,
dans lequel l'implantation de compensation s'effectue avec du bore.

11. Procédé de fabrication suivant l'une des revendications 5 à 10,
dans lequel l'implantation de compensation est effectuée avant l'implantation avec la substance de dopage du premier type de conductivité.

12. Procédé de fabrication suivant l'une des revendications 5 à 11,
dans lequel l'implantation de compensation s'effectue à une dose plus petite que l'implantation avec la substance de dopage du premier type de conductivité.
